# FASCICULE DE BREVET EUROPEEN

(11) **EP 1 273 049 B1**
(45) Date de publication et mention de la délivrance du brevet: **14.09.2011**
(21) Numéro de dépôt: 01923799.9
(22) Date de dépôt: 11.04.2001
(51) Int. Cl.: H01L 33/00, H01L 33/06, H01L 33/08, H01L 33/32

(54) **PROCEDE DE PREPARATION D'UNE COUCHE MINCE SEMI-CONDUCTRICE DE GaInN**
HERSTELLUNGSVERFAHREN EINER HALBLEITER-DÜNNSCHICHT AUS GaInN
METHOD FOR PREPARING A THIN SEMICONDUCTOR GaInN LAYER

(30) Priorité: 12.04.2000 FR 0004683
(43) Date de publication de la demande: 08.01.2003
(73) Titulaire: CENTRE NATIONAL DE LA RECHERCHE SCIENTIFIQUE (CNRS), 75794 Paris Cedex 16 (FR)
(72) Inventeur: MASSIES, Jean, Claude, F-06560 Valbonne (FR); GRANDJEAN, Nicolas, Pierre, 06110 Le Cannet (FR); DAMILANO, Benjamin, Gérard, Pierre, F-06340 La Trinité (FR)
(74) Mandataire: Jacquard, Philippe Jean-Luc
(86) Numéro de dépôt international: PCT/FR2001/001115
(87) Numéro de publication internationale: WO 2001/078157

(56) Documents cités:
- US-A- 5 851 905
- ROBERTS J ET AL: "Stacked InGaN/AlGaN double heterostructures" III-V NITRIDES, BOSTON, DEC 1996, pages 1161-1165, XP000872583
- DAMILANO B ET AL: "From visible to white light emission by GaN QDs on Si(111)" APPLIED PHYSICS LETTERS, AUG 1999, vol. 75, no. 7, pages 962-964, XP002155115 ISSN: 0003-6951 cité dans la demande
- PATENT ABSTRACTS OF JAPAN vol. 1999, no. 08, 30 juin 1999 (1999-06-30) -& JP 11 087773 A (TOSHIBA CORP), 30 mars 1999 (1999-03-30)
- PATENT ABSTRACTS OF JAPAN vol. 1998, no. 05, 30 avril 1998 (1998-04-30) -& JP 10 022525 A (TOYODA GOSEI CO LTD), 23 janvier 1998 (1998-01-23)

## Description

L'invention concerne le procédé de préparation d'une couche mince, semi-conductrice, de GaInN.

Le domaine technique de l'invention peut être défini comme celui de la production de lumière blanche. La lumière blanche répondant aux critères édictés par la CIE en 1964.

La production de lumière blanche fait actuellement l'objet de nombreuses recherches, afin de mettre au point des dispositifs présentant notamment un faible coût, une consommation d'énergie peu élevée, une longue durée de vie et un bon rendement énergétique.

En effet, la lumière blanche a longtemps été essentiellement produite par les lampes à incandescence dont le rendement et la durée de vie sont très faibles, puisqu'ils sont respectivement voisins de 5 % et de 1 000 heures. Le rendement des tubes fluorescents et leur durée de vie sont supérieurs, puisqu'ils sont voisins de 25 % et de 1 000 heures pour les lampes fluorescentes, mais, ils présentent un certain nombre d'inconvénients : en effet, il s'agit de tubes à vide, compliqués et chers à fabriquer, et qui, en outre, contiennent plusieurs milligrammes de mercure hautement toxique, leur destruction en fin de vie pose donc un sérieux problème environnemental.

De plus, les tubes fluorescents produisent une lumière qui n'est pas agréable, ce qui limite souvent leur utilisation.

En terme d'efficacité, les meilleures lampes industrielles actuelles sont les lampes à basse pression de sodium, qui ont une efficacité de l'ordre de 35 %. Il s'agit, comme pour les tubes fluorescents, de lampes peu agréables, voire inacceptables pour un éclairage courant à cause de leur couleur. La recherche s'est donc orientée vers d'autres dispositifs qui soient sûrs, solides, fiables, de grande durée de vie, susceptibles de produire de la lumière blanche à faible coût avec un rendement énergétique supérieur ou égal à celui des dispositifs mentionnés plus haut.

A titre d'exemple, de telles sources de lumière blanche ont été envisagées, entre autres,... les phosphores, les polymères électroluminescents et les semi-conducteurs.

Les polymères électroluminescents, tels que le PPV, sont très bon marché et la technologie pour leur mise en oeuvre, qui consiste simplement à intercaler le polymère entre des électrodes semi-transparentes, est très simple. Toute la gamme des couleurs visibles peut être obtenue et l'émission de blanc se fait soit par combinaison de couleurs, soit par utilisation d'un seul composé de spectre assez large. Cependant, ces composés ne sont utilisés actuellement que pour l'illumination d'écrans à cristaux liquides en lumière orange. La faible durée de vie des émetteurs de vert et de bleu de ce type interdit la production de lumière blanche par ces polymères électroluminescents.

La production de lumière blanche par les semi-conducteurs repose essentiellement sur les nitrures et, en particulier, les nitrures d'éléments du groupe III, qui, seuls, émettent du vert ou du bleu avec une grande efficacité et une grande longévité. Le composé de type nitrure le plus utilisé est GaInN qui émet de la lumière du bleu au rouge.

Une couche mince de nitrures, par exemple, de GaInN, insérée dans un matériau, tel que le Ga(Al)N et dont la bande interdite fixe la longueur d'onde d'émission et donc la couleur, constitue ainsi la brique élémentaire de la zone active des Diodes Electroluminescentes (DEL) de haute brillance.

L'épaisseur de la couche de GaInN est généralement inférieure ou égale à 10nm (100 Å) et l'on parle alors communément de DEL à puits quantiques GaInN/Ga(Al)N dont l'émission est centrée sur une couleur particulière, par exemple, le bleu ou le vert.

Il est couramment admis que la composition en indium et/ou l'épaisseur de la couche de GaInN fixe l'énergie de transition du puits quantique, et, par conséquent, la longueur d'onde d'émission de la DEL. Les puits quantiques GaInN/Ga(Al)N présentent cependant, pour des compositions en indium supérieures à 10 %, des propriétés optiques tout à fait particulières, parmi lesquelles on peut mentionner la durée de vie radiative anormalement longue des excitons et la variation très faible de l'énergie de la bande interdite en fonction de la pression.

Les DEL'S bleues de haute brillance, dont le rendement est d'ores et déjà très élevé (supérieur à 10 %), permettent la production de lumière blanche par une technologie hybride, dans laquelle la DEL bleue sert au pompage de phosphores ou de polymères. La combinaison de la luminescence jaune de ces composés avec celle de la DEL produit de la lumière blanche par addition de couleurs. Cette technologie est actuellement largement utilisée aussi bien par NICHIA^{®}, que par HEWLETT-PACKARD^{®}, GELCORE^{®} ou par SIEMENS-OSRAM^{®} et son application à l'éclairage domestique est tout à fait prometteuse.

Cependant, le couplage d'une DEL et d'un autre constituant, tel que le phosphore ou le polymère, en vue d'obtenir de la lumière blanche, est, du fait de son caractère hybride, un procédé coûteux et complexe, comprenant plusieurs étapes technologiques, impliquant, par exemple, le dépôt sur une DEL bleue, a posteriori, d'un composé de type phosphore ou polymère avant encapsulation.

L'équilibrage des couleurs avec un dispositif hybride DEL-polymère/phosphore n'est pas facile et l'on n'obtient pas aisément un blanc qualifié d' « agréable » pour l'éclairage domestique. En outre, le dispositif, à l'instar du procédé pour sa préparation, est complexe, comporte de nombreux éléments et est donc moins fiable que la DEL nitrure de base dont la durée de vie intrinsèque est d'environ 100 000 heures.

Enfin, de manière inhérente, le rendement d'un système hybride, dans lequel les pertes sont inévitables, est inférieur à celui de la DEL nitrure de pompe.

Il serait donc intéressant de disposer de diodes électroluminescentes DEL émettant directement de la lumière blanche, pour s'affranchir des inconvénients des dispositifs hybrides impliquant le couplage d'une DEL bleu (ou verte) avec un phosphore ou polymère.

Il a été récemment montré, dans l'article de B. DAMILANO, N. GRANDJEAN, F. SEMOND, J. MASSIES et M. LEROUX, Appl. Phys. Lett. 75, 962 (1999), qu'il était possible de produire de la lumière blanche sous excitation optique, au moyen d'un laser, dans une structure monolithique à base de semi-conducteurs nitrures d'éléments III de la classification périodique. Il s'agit d'un empilement de quatre plans de boîtes quantiques GaN séparés par des couches d'AlN. La taille des boîtes quantiques fixe la longueur d'onde d'émission et il suffit donc d'ajuster celle-ci dans chaque plan de façon à ce que l'émission résultante des quatre plans soit blanche par le simple principe de l'addition des couleurs. Cette structure ne peut malheureusement pas être utilisée comme zone active dans un dispositif optoélectronique de type diode électroluminescente (DEL) pour une raison simple : le matériau AIN ne peut être dopé de type p.

De plus, l'injection électrique dans ce type de structure est difficile à contrôler et peut poser un problème d'équilibrage des couleurs qui rend finalement difficile la production de blanc.

Le document JP 11087773 décrit un élément émettant de la lumière composée de plusieurs longueurs d'onde, l'élément étant constitué de plusieurs couches actives en InGaN, avec des couches barrières en InGaN interposées.

Il existe donc un besoin pour une couche semi-conductrice émettant directement de la lumière blanche (ou toute autre lumière résultant de la combinaison de plusieurs couleurs, notamment de couleurs primaires), qui puisse être insérée directement comme zone active dans une DEL, à l'instar des puits quantiques GaInN/Ga(Al)N, aujourd'hui utilisés pour ces DEL'S commerciales bleues et vertes ; cette couche unique pouvant être fabriquée, simplement, à faible coût par un procédé sûr, fiable, éprouvé et présentant un nombre limité d'étapes.

Le but de la présente invention est, entre autres, de répondre à ces besoins.

Ce but et d'autres encore sont atteints, conformément à la présente invention, par une couche mince, semi-conductrice, unique, de GaInN, émettant au moins deux lumières visibles, de couleurs déterminées dont l'addition peut notamment permettre d'obtenir de la lumière blanche, ladite couche étant préparée par le procédé revendiqué.

Par couche de GaInN, on entend une couche de GaInN, ou de GaInN contenant éventuellement un faible pourcentage, par exemple, d'arsenic, de phosphore ou d'antimoine.

Par faible pourcentage, on entend généralement un pourcentage inférieur à 5 %.

Plus précisément, la couche mince obtenue par un procédé selon l'invention est formée par la juxtaposition ou superposition d'au moins deux dépôts de GaInN (de même composition ou de composition différente) dont chacun émet une lumière visible d'une couleur déterminée.

Avantageusement, la combinaison desdites au moins deux lumières visibles de couleurs déterminées produit de la lumière blanche.

Selon l'invention, on obtient, de manière totalement inattendue, l'émission de plusieurs lumières de couleurs déterminées différentes, à partir d'une seule et même couche mince, unique, de GaInN. Jusqu'à présent, il n'était possible, à partir d'une seule couche mince de GaInN, de n'obtenir qu'une seule lumière de couleur bien définie, par exemple bleue, verte ou jaune, comme c'est le cas dans les puits quantiques bleus ou verts, actuellement utilisés dans les DEL'S.

On obtient, selon l'invention, plusieurs émissions de lumière de couleurs déterminées et différentes, non plus à partir de plusieurs couches, nettement délimitées de GaIn(Al)N, séparées par des barrières, par exemple, de Ga(Al)N, mais bien à partir d'une seule et même couche mince, de GaInN.

La couche obtenue par un procédé selon la présente invention se différencie donc fondamentalement de la structure complexe du document de DAMILANO et al., cité plus haut. En effet, dans ce document, ce sont quatre couches différentes séparées, indépendantes, isolées, qui émettent avec des longueurs d'onde différentes dont la combinaison est blanche, alors que, selon l'invention, on obtiendrait dans un cas similaire, au contraire, une seule couche qui émettrait, par exemple, quatre longueurs d'onde différentes.

Si l'on avait transposé ce type de structure réalisée pour le système GaN au système GaInN/Ga(Al)N, en plaçant dans une jonction p-n Ga(Al)N au moins deux couches de GaInN séparées par une barrière en Ga(Al)N, leur émission serait centrée, par exemple, l'une sur le jaune et l'autre sur le bleu et l'émission résultante globale serait du blanc, selon les critères CIE 1964. Cependant, dans le type de structure, il n'est pas aisé de contrôler l'injection électronique dans les différentes couches de GaInN, ce qui pose un problème d'équilibrage des couleurs et rend difficile la production de blanc.

L'approche adoptée, selon l'invention, est fondamentalement différente, puisqu'une seule et même couche mince semi-conductrice, à base d'alliage de GaInN, émet non plus une seule couleur, mais plusieurs couleurs, dont la combinaison fournit, de préférence, de la lumière blanche. Indiquons au passage qu'il est possible d'émettre dans tout le spectre visible et de manière continue, à partir de la couche mince unique obtenue par le procédé selon l'invention. Si la combinaison de ces lumières visibles de couleurs déterminées produit, de préférence, de la lumière blanche, toute lumière d'une couleur issue de la combinaison de deux lumières de couleurs déterminées ou plus peut être obtenue par la couche obtenue par le procédé selon l'invention. Ces lumières de couleurs déterminées, différentes, sont, de préférence, des couleurs dites primaires : bleue, verte ou rouge.

Le blanc peut s'obtenir, par exemple, à partir de trois dépôts, qui émettent, respectivement, des lumières bleue, verte et rouge, le blanc peut de même s'obtenir à partir de deux dépôts seulement, qui émettent, respectivement, des lumières bleue et jaune.

De manière totalement inattendue et qui va à l'encontre de ce qui était communément admis jusqu'à présent, les inventeurs ont mis en évidence, à partir d'expériences menées en photoluminescence sur des échantillons réalisés en laboratoire en Epitaxie par Jets Moléculaires (EJM), que les hétérostructures GaInN/GaN n'ont pas le comportement attendu pour des puits quantiques. Plus précisément, les inventeurs ont démontré, de manière surprenante, que l'émission de photons dans l'alliage GaInN provient de porteurs extrêmement localisés dont l'extension de la fonction d'onde associée est de l'ordre de quelques mailles atomiques. La mise en évidence expérimentale de la très forte localisation des porteurs dans l'alliage GaInN est notamment à la base de la présente invention, puisqu'elle permet de juxtaposer différents dépôts de GaInN, d'épaisseur voisine, par exemple, de quelques nanomètres, sans qu'il y ait couplage des fonctions d'onde, ce qui aboutirait à un seul niveau d'énergie.

En effet, si l'on considère une fine couche d'un matériau semi-conducteur A d'épaisseur Lw, insérée dans un matériau B à bande interdite plus grande, l'énergie E(Lw) du puits quantique B/A/B est fixée par Lw. Si l'on réalise deux dépôts de matériau A de largeur Lw₁ et Lw₂, l'énergie du puits quantique B/A/A/B est unique et ne dépend que de Lw₁ + Lw₂. Si l'on insère une très fine barrière de matériau B de largeur Lb entre les deux dépôts de matériau A, nous avons alors un système à puits quantiques couplés B/A/B/A/B dont le niveau de base dépend de Lw₁, Lw₂ et Lb. Dans les semi-conducteurs traditionnels, de type arséniure (tel que le GaAs), les fonctions d'ondes associées aux porteurs - électron et trou - ont des extensions latérales de plusieurs dizaines d'Angströms. Aussi, la barrière Lb doit-elle être supérieure à 10nm (100 Å) pour découpler les deux puits et observer l'émission de chacun d'entre eux. Dans les puits quantiques à base de GaInN, il a été mis en évidence, selon l'invention, ce qui est inattendu, que la fonction d'onde des porteurs est si localisée qu'il n'y a plus de couplage entre puits, même pour des épaisseurs de barrières très fines, par exemple inférieures au nanomètre. En fait, la juxtaposition de deux dépôts de GaInN, c'est-à-dire sans croissance intermédiaire d'une barrière Ga(Al)N, d'épaisseurs différentes correspondant à des énergies de transitions différentes, conduit aux deux transitions distinctes. Il est donc possible, selon l'invention, de réaliser une couche mince de GaInN dont l'épaisseur est inférieure ou égale à 10nm (100Å) présentant des maxima d'émissions à différentes longueurs d'onde, sans couplage.

Ainsi, il a été réalisé en épitaxie, par EJM et par épitaxie en phase vapeur d'organo-métalliques (EPVOM), des hétérostructures GaInN/GaN, émettant, à température ambiante dans tout le domaine visible, du bleu (0,4 µm) au rouge (0,66 µm).

L'invention concerne, un procédé de préparation d'une couche mince, semi-conductrice, de GaInN, selon la revendication 1. Des modes de réalisation particuliers d'un tel procédé font l'objet des revendications dépendantes.

Selon l'invention, la couche unique, de GaInN est déposée, non pas de façon continue, mais de façon séquentielle, avec une interruption de croissance entre chaque dépôt. En d'autres termes, le dépôt de GaInN est fractionné et une interruption de croissance doit être réalisée pour obtenir que chaque dépôt émette une lumière de couleur déterminée, après dépôt d'une quantité ad hoc de GaInN.

En outre, selon l'invention, il a été mis en évidence, de manière totalement surprenante, que l'épaisseur de GaInN n'est pas directement le facteur qui détermine l'énergie de transition et donc la couleur de la lumière émise d'une hétérostructure GaInN/GaN, contrairement à ce qui est connu pour les semi-conducteurs III - V classiques, tels que GaAs/AlGaAs ou GaInAs/GaAs, par exemple, mais plutôt étonnamment, la température et/ou la durée de croissance du dépôt, et/ou la température pendant l'interruption de croissance et/ou la durée de ladite interruption.

En relation avec ce qui a déjà été expliqué plus haut, les inventeurs ont, par une série d'expériences menées en laboratoire, apporté la preuve que les objets responsables de la luminescence dans GaInN sont de tailles nanométriques, voire subnanométriques.

Ces objets se forment pendant la croissance de GaInN et leur taille et, par voie de conséquence, leur énergie dépendent du temps de dépôt et/ou des conditions de croissance.

De manière préférée, on fixe la couleur de la lumière émise par chacun des dépôts, en agissant sur la durée et/ou la température de la croissance de chacun des dépôts.

On peut éventuellement effectuer une remontée en température, lors de l'interruption de croissance, entre chaque dépôt. Par ailleurs, les objets, cités ci-dessus, tels que « clusters » d'InN, paires In - In, qui se forment pendant la croissance et entraînent une très forte localisation des porteurs, et par conséquent, toute absence de couplage, sont de nature intrinsèque et ne dépendent pas de la technique de dépôt, de croissance, utilisée. En d'autres termes, les propriétés inattendues des couches décrites ici sont liées intrinsèquement à l'alliage GaInN et ne dépendent pas de la technique de dépôt utilisé. Celle-ci pourra donc être toute technique connue de l'homme du métier : cela constitue un avantage extrêmement important de la présente invention.

Les dépôts pourront donc être réalisés par Epitaxie par Jets Moléculaires (EJM), mais aussi par Epitaxie en Phase Vapeur d'Organométalliques (EPVOM).

Il est extrêmement intéressant, selon l'invention, que la technique d'EPVOM puisse être mise en oeuvre, car c'est la technique qui est aujourd'hui généralement utilisée dans la fabrication des DEL'S nitrures bleues, vertes et blanches.

On peut ainsi surmonter tous les inconvénients liés aux dispositifs de production de lumière blanche de l'art antérieur et produire de la lumière blanche à bas coût, faible consommation d'énergie, très longue durée de vie (par exemple 100 000 heures), très basse tension et sans toxicité.

La lumière blanche est produite selon l'invention directement par électroluminescence, par un seul élément et donc de façon monolithique (sans « converter »), sans avoir recours à des techniques hybrides complexes et donc coûteuses, basées sur le couplage d'une DEL bleue et d'un autre constituant phosphore ou polymère. Le rendement d'un système monolithique, obtenu par le procédé selon l'invention, est, de manière évidente, meilleur que celui d'un système hybride dans lequel les pertes sont inévitables.

De la même manière que les puits quantiques GaInN/Ga(Al)N, actuellement utilisés dans les DEL'S commerciales bleues ou vertes, la couche mince, obtenu par le procédé selon l'invention, peut être facilement insérée directement comme zone active dans une DEL.

La présente invention permet de réduire le coût des DEL'S blanches, puisqu'il n'est plus nécessaire d'utiliser un phosphore ou un polymère en plus d'une DEL bleue nitrures pour la production de blanc. Cela élimine un certain nombre d'étapes technologiques introduites par le dépôt du phosphore/polymère sur les DEL'S, avant encapsulation, et donc une simplification du procédé de fabrication. Les autres étapes du procédé restent les mêmes et ne nécessitent aucune modification, puisque l'invention ne concerne que la zone active des DEL'S.

Les DEL'S et dispositifs de production de lumière obtenu par le procédé selon l'invention sont donc fiables, simples, solides, à grande durée de vie, peu coûteux, préservant l'environnement, faciles à fabriquer et produisant une lumière agréable. Il est possible, lors de ce procédé, d'équilibrer facilement les couleurs, afin d'obtenir un blanc « agréable » pour l'éclairage domestique ou ayant une dominante à la demande. En outre, la fiabilité du dispositif ne peut être qu'améliorée en raison de sa simplicité. Il faut savoir qu'une LED nitrures a une durée de vie estimée à environ 100 000 heures.

Un mode de réalisation de la présente invention, dans lequel on fixe la couleur de chacun des dépôts, en agissant sur les durées de dépôts, va maintenant être décrit plus en détail, en référence aux dessins joints, dans lesquels :

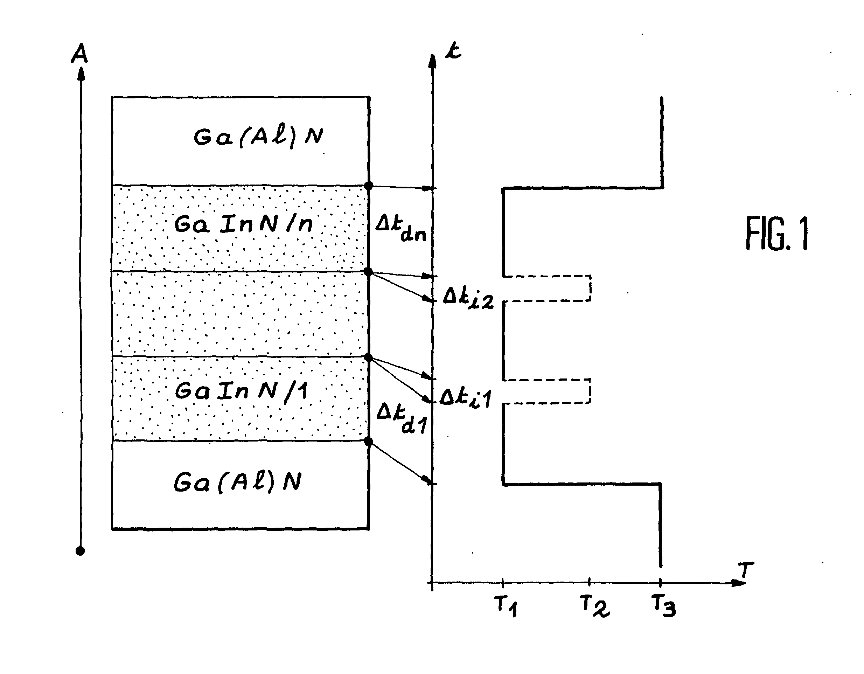

- La figure 1 illustre la préparation par le procédé de l'invention d'une hétérostructure comprenant des couches barrières de Ga(Al)N, entre lesquelles est disposée une couche mince. La partie gauche du graphique, comprenant un axe de croissance (A), illustre la croissance des couches et dépôts, en fonction du temps (t) ; la partie droite du graphique montre les températures de croissance (T), utilisées au cours du temps, lors de la croissance des divers couches et dépôts, ainsi que lors des interruptions de croissance (parties en pointillés).

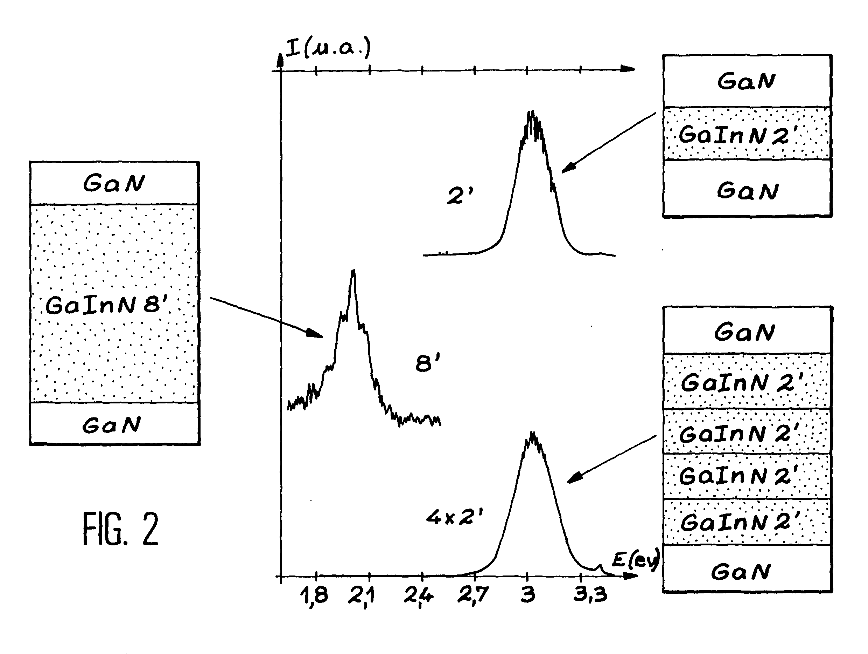

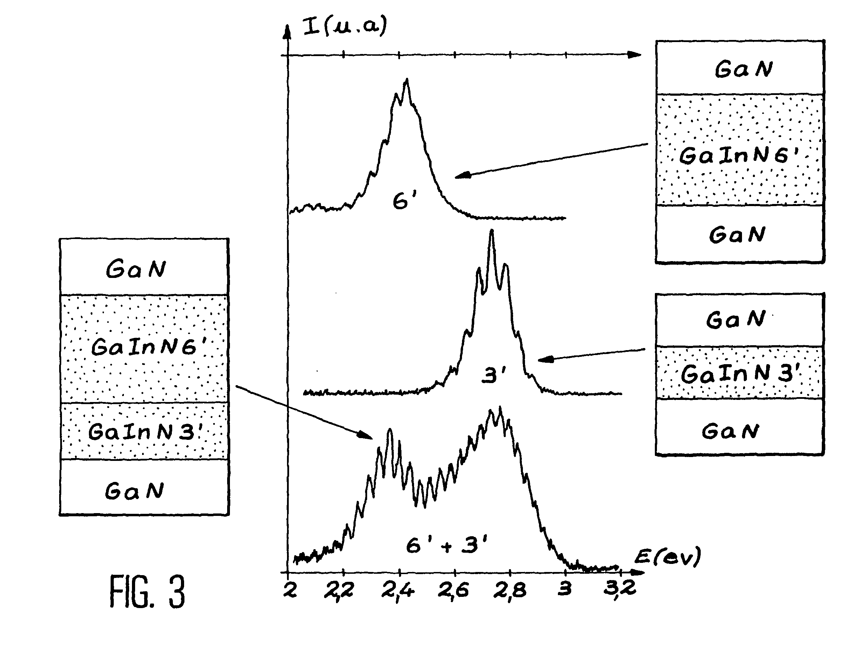

- Les figures 2 et 3 sont des graphiques qui donnent l'intensité de photoluminescence (I en unité arbitraire), en fonction de l'énergie de photoluminescence (E en eV), à température ambiante, pour diverses couches de GaInN préparées en fractionnant le dépôt dans le temps ou sans fractionner le dépôt dans le temps, et en faisant varier la durée du ou des dépôts (8, 2, 6, 3 minutes).

La réalisation d'une couche mince de GaInN, émettant de la lumière blanche, nécessite, dans un premier temps, l'étalonnage en longueur d'onde de l'hétérostructure comprenant une couche de GaInN et des couches barrières, de préférence, de Ga(Al)N, en fonction des conditions de croissance de l'alliage GaInN. Il est, en effet, nécessaire de couvrir une bonne partie du spectre visible, au moins du bleu au jaune, pour pouvoir, par addition de couleurs, obtenir du blanc, par exemple, par combinaison des lumières bleue et jaune.

Une fois l'étalonnage effectué, les différents dépôts de GaInN, correspondants aux couleurs voulues, sont réalisés par le procédé de l'invention, afin d'obtenir, par superposition, juxtaposition, des différents dépôts de GaInN de même composition ou de compositions différentes, une couche mince, unique, émettant une couleur résultant de l'addition des couleurs déterminées, différentes, émises par chacun des dépôts.

Dans un dispositif de type DEL, le dépôt de la couche mince, selon l'invention, se fait généralement sur une couche barrière formant substrat, qui est, par exemple, une couche de Ga(Al)N, généralement de type n. L'hétérostructure se termine par une couche barrière, cette couche terminale est, par exemple, une couche de Ga(Al)N généralement de type p.

Dans le mode de réalisation décrit, afin d'obtenir, selon l'invention, une émission de lumière blanche à partir d'une seule et même couche mince de GaInN, on effectue le dépôt de cette couche, non pas de façon continue, mais de façon séquentielle, fractionnée dans le temps, avec interruption de croissance, après chaque dépôt de GaInN.

Le procédé utilisé est décrit schématiquement sur la figure 1. Sur cette figure, les températures T₁, T₂ et T₃ représentent les températures utilisées, respectivement, pour les n dépôts de GaInN (T₁) : GaInN/1, GaInN/2,..., GaIn/N, pour l'éventuelle remontée en température ou recuit pendant l'interruption de croissance (T₂), et pour le dépôt des couches barrières substrat et terminale, de préférence, de Ga(Al)N (T₃).

La température T₁ est généralement comprise entre 500° et 800°C.

La température T₂ est généralement de 500° à 800°C.

La température T₃ est généralement de 750° à 1 050°C.

Dans ce mode de réalisation, la couleur de la lumière émise par chacun des dépôts est fixée par la durée de ceux-ci, les autres paramètres de croissance, tels que la température, comme on l'a indiqué ci-dessus, restant constants. Ainsi, les durées des dépôts séquentiels de GaInN correspondent-elles à Δtd₁, Δtd₂,..., Δtdₙ, à titre d'exemple, les durées de dépôts sont de 2 à 8 minutes. A chaque durée de dépôt correspond une lumière émise de couleur déterminée. Après chaque dépôt, on observe une interruption de croissance d'une durée Δti₁, Δti₂,.... Cette interruption de croissance peut s'accompagner, mais cela n'est pas forcément nécessaire, et dépend des conditions de croissance, d'une remontée en température ou recuit (T₂), par exemple, jusqu'à 100° ou 200°C au-dessus de T₁.

Une fois tous les dépôts formant la couche mince effectués, chaque dépôt correspondant à une couleur et la combinaison de l'ensemble des couleurs produisant, de préférence, de la lumière blanche, on effectue le dépôt de la couche terminale généralement de Ga(Al)N de type p.

L'invention va maintenant être décrite en référence aux exemples suivants, donnés à titre illustratif et non limitatif.

### Exemple 1

On réalise par Epitaxie par Jets Moléculaires (EJM) le dépôt d'une couche mince de GaInN sur une couche substrat de GaN préalablement déposée sur un substrat ad-hoc qui peut être par exemple GaN lui-même, le saphir, le silicium, ou le carbure de silicium, dans les conditions de croissance suivantes : la couche est déposée en continu en une seule fois avec une durée de dépôt de deux minutes (Δt_{d1} = 2', n = 1), sans fractionner le dépôt dans le temps. La couche terminale est également du GaN. On obtient ainsi une hétérostructure émettant dans le violet (voir figure 2, courbe en haut à droite).

### Exemple 2

On réalise le dépôt d'une couche mince de GaInN par EJM dans les mêmes conditions que celles de l'exemple 1, sauf que la couche est déposée en continu en une seule fois avec une durée de dépôt de huit minutes (Δtd₁ = 8', n = 1). On obtient ainsi une hétérostructure émettant dans le rouge (voir figure 2, courbe au milieu à gauche).

### Exemple 3

On réalise le dépôt d'une couche mince de GaInN par EJM dans les mêmes conditions que celles de l'exemple 2, le temps total de dépôt étant de huit minutes, mais on fractionne le temps de dépôt du GaInN en quatre dépôts successifs de même composition avec durée de dépôt de deux minutes pour chaque dépôt (Δtd₁ = Δtd₂ = Δtd₃ = Δtd₄ = 2', n = 4), avec interruption de croissance entre chaque dépôt (d'une durée de 1 minute) et remontée en température d'un incrément de 100 - 200°C par rapport à la température de croissance. On obtient ainsi une hétérostructure émettant de nouveau dans le violet, soit l'énergie correspondant à une seule fois deux minutes (voir figure 2, courbe en bas à droite).

### Exemple 4

On réalise le dépôt d'une couche mince de GaInN par EJM dans les mêmes conditions que celles de l'exemple 1, mais la couche est déposée en continu en une seule fois avec une durée de dépôt de trois minutes (Δtd₁ = 3', n = 1).

On obtient ainsi une hétérostructure émettant dans le bleu (voir figure 3, courbe du milieu).

### Exemple 5

On réalise le dépôt d'une couche mince de GaInN par EJM dans les mêmes conditions que celles de l'exemple 1, sauf que la couche est déposée en continu, en une seule fois, avec une durée de dépôt de six minutes (Δtd₁ = 6', n = 1). On obtient ainsi une hétérostructure émettant dans le jaune - vert (voir figure 3, courbe du haut).

### Exemple 6

On réalise le dépôt d'une couche mince de GaInN selon l'invention, par EJM, dans les mêmes conditions que celles des exemples 4 et 5, mais on fractionne le temps de dépôt. En réalisant un dépôt fractionné dans le temps, on réalise successivement un premier dépôt de GaInN pendant une durée de trois minutes (Δtd₁ = 3') avec les conditions de croissance de l'exemple 4, puis un second dépôt de GaInN de même composition nominale que le premier dépôt, pendant une durée de six minutes (Δtd₂ = 6', n = 2), comme dans l'exemple 5. Les autres conditions de croissance demeurent identiques lors des premier et second dépôts et on observe une courte interruption de croissance entre les deux dépôts (d'une durée d'environ 1 minute) avec une remontée en température de 100° à 200°C par rapport à la température de croissance. On constate sur la figure 3 (courbe du bas) que le spectre de photoluminescence correspondant à cet échantillon comporte bien l'émission de chacun des dépôts de GaInN prise séparément, bien que la couche obtenue soit unique.

Sans optimisation, la combinaison des deux pics d'émission de chacun des dépôts donne lieu à une luminescence proche du blanc. Cet exemple et la figure 3 démontrent qu'en fractionnant le temps de dépôt de l'alliage GaInN, il est possible d'obtenir une émission de lumière blanche à partir d'une seule et même couche mince de GaInN, obtenue par un procédé conforme à l'invention : à chaque temps de croissance de GaInN correspond une couleur et la combinaison de l'ensemble des couleurs produit de la lumière blanche. On aurait pu obtenir le même résultat en combinant trois couleurs, telles que le bleu, le vert et le rouge, au lieu de deux. De même, il a été démontré que des résultats analogues étaient obtenus par EPVOM.

## Revendications

1. Procédé de préparation d'une couche mince semi-conductrice de GaInN, ladite couche étant formée par au moins deux dépôts de GaInN, chacun desdits dépôts étant adapté pour émettre une lumière visible d'une couleur déterminée différente, dans lequel la formation de ladite couche est réalisée de manière fractionnée dans le temps, en effectuant successivement lesdits dépôts de GaInN sans étape de dépôt intermédiaire, une interruption de croissance étant prévue entre chaque dépôt, chacun desdits dépôts étant adapté pour émettre une lumière visible de couleur déterminée.

2. Procédé selon la revendication 1, dans lequel la couleur de la lumière émise par chacun des dépôts est fixée en agissant sur au moins un paramètre choisi parmi :
- la température de la croissance du dépôt ;
- la durée de la croissance du dépôt ;
- la température pendant l'interruption de croissance ; et
- la durée de ladite interruption.

3. Procédé selon l'une des revendications précédentes, dans lequel on effectue, en outre, une remontée en température lors de l'interruption de croissance.

4. Procédé selon l'une quelconque des revendications précédentes, dans lequel les dépôts sont réalisés par un procédé choisi parmi :
- l'Epitaxie par Jets Moléculaires (EJM) ; et
- l'Epitaxie en Phase Vapeur d'Organo-Métalliques (EPVOM).

5. Procédé selon l'une quelconque des revendications précédentes, dans lequel lesdits dépôts de GaInN ont tous la même composition.

6. Procédé selon l'une quelconque des revendications précédentes, dans lequel les couleurs des aux moins deux lumières visibles sont choisies de telle manière que leur combinaison produise de la lumière blanche.

7. Procédé selon l'une des revendications précédentes, dans lequel lesdits dépôts sont au nombre de trois et sont adaptés pour émettre respectivement des lumières bleue, verte et rouge.

8. Procédé selon l'une des revendications 1 à 6, dans lequel lesdits dépôts sont au nombre de deux et sont adaptés pour émettre respectivement des lumières bleue et jaune.

9. Procédé selon l'une des revendications précédentes, dans lequel l'épaisseur de ladite couche est inférieure ou égale à 10 nm (100 Å).

10. Procédé selon l'une des revendications précédentes, dans lequel ladite couche contient un pourcentage d'arsenic, de phosphore, ou d'antimoine inférieur ou égal à 5%.

## Claims

1. Method for preparing a thin, semiconducting layer of GaInN formed by at least two deposits of GaInN, each of said deposits being adapted to emit visible light of a different particular colour, in which said layer is formed in different time steps, by successively making said deposits of GaInN with no intermediate deposition step, an interruption in growth being provided between each deposit and the next, each of said deposits being adapted to emit visible light of a particular colour.

2. Method according to claim 1, in which the colour of the light emitted by each of the deposits is fixed by varying at least one parameter chosen from:
- the growth temperature of the deposit;
- the growth duration of the deposit;
- the temperature during the interruption of growth; and
- the duration of said interruption.

3. Method according to either of the preceding claims in which the temperature is furthermore increased during the interruption of growth.

4. Method according to any one of the preceding claims, in which the deposits are produced by a method chosen from:
- molecular beam epitaxy (MBE), and
- organometallic vapour phase epitaxy (OMVPE).

5. Method according to any one of the preceding claims, in which said deposits of GaInN all have the same composition.

6. Method according to any one of the preceding claims, in which the at least two colours of visible light are chosen so that their combination produces white light.

7. Method according to any one of the preceding claims, in which there are three of said deposits and they are respectively adapted to emit blue, green and red light.

8. Method according to any one of claims 1 to 6, in which there are two of said deposits and they are respectively adapted to emit blue and yellow light.

9. Method according to any one of the preceding claims, in which the thickness of said layer is less than or equal to 10 nm (100 Å) .

10. Method according to any one of the preceding claims, in which said layer contains a percentage of arsenic, phosphorus or antimony less than or equal to 5%.

## Patentansprüche

1. Verfahren zum Herstellen einer Halbleiter-Dünnschicht aus GaInN, wobei die Schicht aus zumindest zwei GaInN-Abscheidungen gebildet wird, wobei jede Abscheidung darauf abgestimmt ist, sichtbares Licht mit bestimmter unterschiedlicher Farbe zu emittieren, wobei die Bildung der genannten Schicht zeitlich aufgeteilt erfolgt, indem die GaInN-Abscheidungen aufeinanderfolgend ohne den Schritt einer Zwischenabscheidung durchgeführt werden, wobei eine Wachstumsunterbrechung zwischen jeder Abscheidung vorgesehen ist, wobei jede Abscheidung darauf abgestimmt ist, sichtbares Licht einer bestimmten Farbe zu emittieren.

2. Verfahren nach Anspruch 1, wobei die Farbe des von jeder Abscheidung emittierten Lichts durch Beeinflussen von zumindest einem Parameter festgelegt wird, der ausgewählt ist aus:
- der Temperatur beim Wachstum der Abscheidung;
- der Dauer des Wachstums der Abscheidung;
- der Temperatur während der Wachstumsunterbrechung; und
- der Dauer der Unterbrechung.

3. Verfahren nach einem der vorangehenden Ansprüche, wobei ferner während der Wachstumsunterbrechung ein Anheben der Temperatur erfolgt.

4. Verfahren nach einem der vorangehenden Ansprüche, wobei die Abscheidungen mit einem Verfahren durchgeführt werden, das ausgewählt ist aus:
- der Molekularstrahlepitaxie (MBE); und
- der metallorganischen Gasphasenepitaxie (MOVPE).

5. Verfahren nach einem der vorangehenden Ansprüche, wobei die GaInN-Abscheidungen alle die gleiche Zusammensetzung aufweisen.

6. Verfahren nach einem der vorangehenden Ansprüche, wobei die zumindest zwei sichtbaren Lichtfarben so ausgewählt sind, dass durch ihre Kombination weißes Licht erzeugt wird.

7. Verfahren nach einem der vorangehenden Ansprüche, wobei drei Abscheidungen vorliegen und darauf abgestimmt sind, blaues, grünes bzw. rotes Licht zu emittieren.

8. Verfahren nach einem der Ansprüche 1 bis 6, wobei zwei Abscheidungen vorliegen und darauf abgestimmt sind, blaues bzw. gelbes Licht zu emittieren.

9. Verfahren nach einem der vorangehenden Ansprüche, wobei die Dicke der Schicht geringer oder gleich 10 nm (100 Å) ist.

10. Verfahren nach einem der vorangehenden Ansprüche, wobei die Schicht einen prozentualen Gehalt an Arsen, Phosphor oder Antimon von kleiner oder gleich 5 % aufweist.
